# EUROPEAN PATENT APPLICATION

(11) **EP 4 325 491 A1**
(43) Date of publication of application: **21.02.2024**
(21) Application number: 23191193.4
(22) Date of filing: 11.08.2023
(51) Int. Cl.: G11C 5/14, G11C 11/417, G06F 1/3225, G06F 1/3234, G11C 8/12

(54) **MEMORY DEVICE**

(30) Priority: 18.08.2022 KR 20220103326
(71) Applicant: Samsung Electronics Co., Ltd., Suwon-si, Gyeonggi-do 16677 (KR)
(72) Inventor: CHO, Dongsik, Suwon-si (KR)
(74) Representative: Marks & Clerk LLP

(57) **Abstract**

A memory device, including a memory block including a plurality of memory chips; an access address decoder configured to: decode an access address based on a memory access request, and output a chip selection signal indicating whether an access request has occurred in units of memory chips based on the decoded access address; a memory power mode controller configured to: read the chip selection signal, based on the access request having not occurred for a first memory chip for a predetermined period, control a power mode of the first memory chip to be a low power mode, and based on the access request having occurred for a second memory chip within the predetermined period, control a power mode of the second memory chip to be a normal mode; and a memory chip power controller configuration register configured to store setting information for controlling the power mode.

## Description

### BACKGROUND

### 1. Field

The disclosure relates to a memory device, and more particularly to a memory device capable of detailed power management.

### 2. Description of the Related Art

A static random access memory (SRAM) is an example of a semiconductor memory device. Unlike a dynamic random access memory (DRAM), which needs to be updated periodically, the contents of an SRAM may be maintained as long as power is supplied and a time taken for input and output may be constant regardless of an address at which data is read or written. The SRAM may have a relatively complex circuit, so its integration is low and its price is high, and may be mainly used for small-capacity memory or cache memory.

### SUMMARY

Provided is a memory device capable of detailed power management.

Additional aspects will be set forth in part in the description which follows and, in part, will be apparent from the description, or may be learned by practice of the presented embodiments.

In accordance with an aspect of the disclosure, a memory device includes a memory block including a plurality of memory chips; an access address decoder configured to: decode an access address based on a memory access request, and output a chip selection signal indicating whether an access request has occurred in units of memory chips based on the decoded access address; a memory power mode controller configured to: read the chip selection signal, based on the access request having not occurred for a first memory chip for a predetermined period, control a power mode of the first memory chip to be a low power mode, and based on the access request having occurred for a second memory chip within the predetermined period, control a power mode of the second memory chip to be a normal mode; and a memory chip power controller configuration register configured to store setting information for controlling the power mode.

In accordance with an aspect of the disclosure, a memory device includes a first memory block comprising a first memory chip and a second memory chip; a memory power mode controller configured to control a power mode of the first memory chip and a power mode of the second memory chip; and a voltage controller configured to control a cell voltage for the first memory block, wherein the memory power mode controller is further configured to transmit a first memory state signal indicating a power state of the first memory block to the voltage controller, and wherein the voltage controller is further configured to transmit a first cell voltage control signal for controlling the cell voltage to the first memory block based on the first memory state signal.

In accordance with an aspect of the disclosure, a memory device includes a first memory block comprising a first memory chip and a second memory chip; a memory power mode controller configured to control a power mode of the first memory chip and a power mode of the second memory chip; and a clock controller configured to control a first clock corresponding to the first memory block, wherein the memory power mode controller is further configured to transmit a first memory state signal indicating a power state of the first memory block to the clock controller, and wherein the clock controller is further configured to transmit a first clock control signal for controlling the clock to the first memory block based on the first memory state signal.

In accordance with an aspect of the disclosure, an operating method for a memory device, includes decoding an access address based on a memory access request; determining whether an access request has occurred in units of memory chips based on the decoded access address; counting an idle time for a memory chip for which the access request has not occurred; and switching a power mode of the memory chip to a low power mode based on a count value corresponding to the counted idle time exceeding a threshold.

In accordance with an aspect of the disclosure, a memory device includes: a memory block including a plurality of memory chips; an access address decoder configured to: decode an access address based on a memory access request, and output a chip selection signal indicating whether an access request has occurred for a memory chip of the plurality of memory chips based on the decoded access address; and a memory power mode controller configured to: read the chip selection signal, determine whether the access request has occurred for the memory chip within a predetermined period of time, and control a power mode of the first memory chip to be one of a low power mode and a normal mode based on a result of the determination.

Embodiments are able to control memory chips to change between a normal power mode and a low power mode depending on whether an access request has occurred within a predefined period. This can enable the memory device to reduce its power consumption by setting memory chips to the low power mode when they have not been accessed within the predefined period. A normal power mode may be a mode that has a higher power consumption that the low power mode. The low power mode may be a retention mode or a power down mode.

At least some of the above and other features of the invention are set out in the claims.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 illustrates a block diagram showing a memory device according to an embodiment.
FIG. 2 illustrates a block diagram showing a memory device according to an embodiment.
FIG. 3 illustrates a block diagram showing a memory device according to an embodiment.
FIG. 4 illustrates a block diagram showing a memory device according to an embodiment.
FIG. 5 illustrates a flowchart showing an operating method for a memory device according to another embodiment.
FIG. 6 illustrates an operation of a memory device according to an embodiment.
FIG. 7 illustrates waveform diagram showing an operation of a memory device according to an embodiment.
FIG. 8 illustrates a block diagram showing a memory device according to an embodiment.
FIG. 9 illustrates a flowchart showing an operating method for a memory device according to another embodiment.
FIG. 10 illustrates a block diagram showing a memory device according to an embodiment.
FIG. 11 illustrates a flowchart showing an operating method for a memory device according to another embodiment.
FIG. 12 illustrates a block diagram showing a memory device according to an embodiment.
FIG. 13 illustrates a view for describing a semiconductor system according to an embodiment.
FIG. 14 illustrates a view for describing a semiconductor system according to an embodiment.

### DETAILED DESCRIPTION OF THE EMBODIMENTS

In the following detailed description, only certain embodiments have been shown and described, simply by way of illustration. As those skilled in the art would realize, the described embodiments may be modified in various different ways, all without departing from the scope of the present disclosure.

Accordingly, the drawings and description are to be regarded as illustrative in nature and not restrictive. Like reference numerals generally designate like elements throughout the disclosure.

In addition, expressions written in the singular may be construed in the singular or plural unless an explicit expression such as "one" or "single" is used. Terms including ordinal numbers such as first, second, and the like are used only to describe various components, and are not to be interpreted as limiting these components. These terms may be used for the purpose of distinguishing one constituent element from other constituent elements.

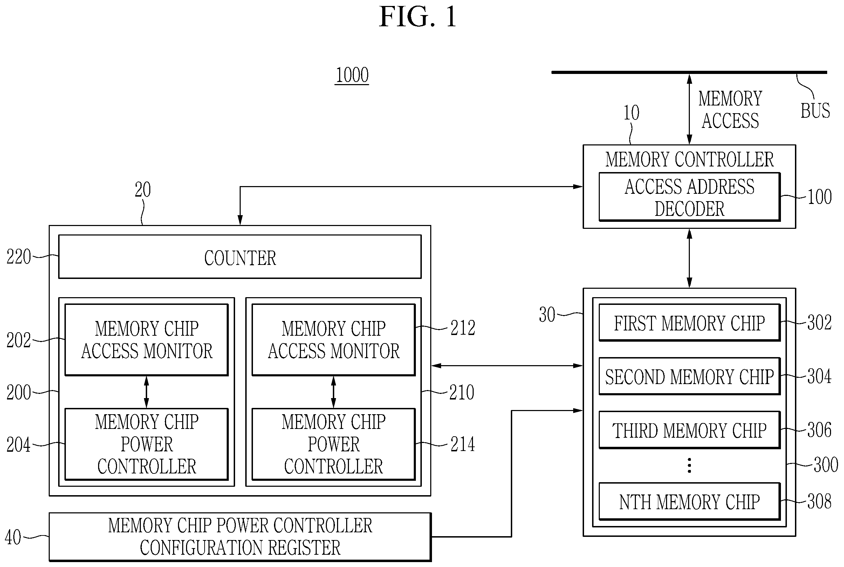

FIG. 1 illustrates a block diagram showing a memory device according to an embodiment.

Referring to FIG. 1, a memory device 1000 according to an embodiment may include a memory controller 10, a memory power mode controller 20, a memory 30, and a memory chip power controller configuration register 40.

The memory controller 10 may control an overall operation of the memory device 1000. For example, when a request for a memory access occurs through a bus, the memory controller 10 may perform a memory access operation. For example, when a read memory access request occurs, the memory controller 10 may read data written in a memory block 300, and transfer the read data to another element through a bus. As another example, when a write memory access request occurs, data provided through the bus of the memory controller 10 may be written to the memory block 300.

In the present embodiment, the memory controller 10 may include an access address decoder 100. The access address decoder 100 may decode an access address from the memory access request. The access address may be address information used to perform an operation for a memory access request. For example, the access address may indicate a position on the memory block 300 at which a data read operation is to be performed when the read memory access request occurs, or may indicate a position on the memory block 300 at which a data write operation is to be performed when the write memory access request occurs.

The access address decoder 100 may output a chip selection signal based on a decoding result thereof. Herein, the chip selection signal may be a signal indicating whether an access request occurs or has occurred in units of memory chips. For example, the access address decoder 100 may analyze the access address to determine or identify which memory chip among a plurality of memory chips 302 to 308 included in the memory block 300 should be accessed, and may output information identifying the determined memory chip as the chip selection signal. In this case, the chip selection signal may be generated by as many as a number of the memory chips 302 to 308.

The memory power mode controller 20 may read the chip selection signal generated by the access address decoder 100 to control the power mode of a memory chip for which an access request has not occurred for a predetermined period among the memory chips 302 to 308 in a low power mode, and may control the power mode of the memory chip for which an access request occurs or has occurred in a normal mode.

The predetermined period may be determined depending on a specific implementation purpose. The memory power mode controller 20 may use a counter 220 to determine whether an access request has not occurred for a predetermined period.

For example, the memory power mode controller 20 may count an idle time of a memory chip for which an access request does not occur by using the counter 220, until a counted value exceeds a threshold, may maintain a power mode of the memory chip for which no access request has occurred in the normal mode, and when the counted value exceeds the threshold value, may switch the power mode of the memory chip for which the access request has not occurred to the low power mode. When an access request occurs while counting is performed, i.e., when a chip selection signal is changed to a value indicating that an access request has occurred before the counted value reaches a threshold, the memory power mode controller 20 may initialize the counter 220, and may maintain the normal mode. The counter 220 may provide a value counting an idle time of the memory chip for which no access request has occurred to memory chip power mode controllers 200 and 210 depending on an implementation method, and the memory chip power mode controllers 200 and 210 may compare the counted value with the threshold so that the power mode of the memory chip for which no access request has occurred for a predetermined period may be switched to the low power mode. Of course, embodiments are not limited thereto, and the implementation method may vary.

The low power mode may be divided into a retention mode and a power down mode depending on data stored in the memory is to be maintained. The retention mode may still apply a cell voltage, for example, such that the memory has been switched to a low power mode but the data stored in the memory cell may be maintained. In the power down mode, because the data stored in the memory cell may be not maintained when the memory is switched to the low power mode, a cell voltage may not be applied, for example.

As such, detailed power management may be possible by controlling the power mode for each of the memory chips 302 to 308. In particular, in the case of a static random access memory (SRAM), as capacity increases, a proportion of power consumed by the SRAM increases compared to a logic circuit, but it may not be possible to perform detailed control for each memory chip depending on a method of controlling power in units of memory blocks. For example, in the method of controlling power in units of memory, the memory block could be switched to the low power mode only when there is no activity for all memory chips included in one memory block. However, according to the present embodiment, power control may be possible for each memory chip included in one memory block, and furthermore, even in the same low power mode, some memory chips in one memory block may be controlled in the retention mode, and for some other memory chips, detailed control such as controlling in the power down mode may be possible, thereby maximizing a power saving effect.

The memory power mode controller 20 may include one or more memory chip power mode controllers 200 and 210. In addition, the one or more memory chip power mode controllers 200 and 210 may be provided by as many as a number of the memory chips 302 to 308. For example, the memory chip power mode controller 200 may control a power mode of a memory chip 302, and the memory chip power mode controller 210 may control a power mode of a memory chip 304. Of course, herein, a number of memory chip power mode controllers 200 and 210 provided may not indicate a number of physical elements, but may indicate a number that is logically divided irrespective of a physically implemented method. In some embodiments, one memory chip power mode controller may control power modes of a plurality of memory chips. For example, the memory chip power mode controller 200 may be implemented to control the power mode of the memory chips 302 and 304, and the memory chip power mode controller 210 may be implemented to control the power mode of the memory chips 306 and 308.

Accordingly, for example, the memory chip power mode controller 200 may read the chip selection signal generated by the access address decoder 100, and when no access request has been made to the memory chip 302 for a predetermined period, may control the power mode of the memory chip 302 in the low power mode, and when an access request has occurred, may control the power mode of the memory chip 302 in a normal mode. In addition, the memory chip power mode controller 210 may read the chip selection signal generated by the access address decoder 100, and when no access request has been made to the memory chip 304 for a predetermined period, may control the power mode of the memory chip 304 in the low power mode, and when an access request has occurred, may control the power mode of the memory chip 304 in a normal mode. For this operation, the memory chip power mode controller 200 may receive a chip selection signal indicating whether an access request to the memory chip 302 occurs or has occurred from the access address decoder 100, and the memory chip power mode controller 210 may receive a chip selection signal indicating whether an access request to the memory chip 304 occurs or has occurred from the access address decoder 100.

In embodiments, the memory chip power mode controller 200 may include a memory chip access monitor 202 and a memory chip power controller 204. The memory chip access monitor 202 may receive and read the chip selection signal generated by the access address decoder 100 to determine whether to control the power mode of the memory chip 302 in the low power mode or the normal mode depending on whether or not an access request has been made to the memory chip 302 for a predetermined period. The memory chip power controller 204 may send a command to the memory chip 302 to control the power mode of the memory chip 302 depending on the determination of the memory chip access monitor 202 through interface with the memory chip 302. Likewise, the memory chip power mode controller 210 may include a memory chip access monitor 212 and a memory chip power controller 214, and the above description may similarly apply to these elements.

The memory 30 may include at least one memory block 300, and the memory block 300 may include a plurality of memory chips 302 to 308. As described above, the power mode may be controlled for each of the memory chips 302 to 308 by the memory power mode controller 20. Herein, one memory chip may be divided, e.g., in units of 64 KB, but embodiments are not limited thereto.

As used herein, a "memory chip" may be included in a "memory block," and may relate to a memory cell array. Because one memory block may be divided into a plurality of memory chips, a size of the memory chip may be smaller than a size of the memory block. In some embodiments, the memory chip may refer to a memory area identified by a chip selection signal generated by the access address decoder 100. For example, a first memory area, which can be connected to the bus to be in a state in which memory access is possible, or can be disconnected from the bus to be in a state in which memory access is possible, and depending on a state of a first chip selection signal, may be distinguished from a second memory area in which memory access is determined by a state of a second chip selection signal that is different from the first chip selection signal, and herein, the first memory area may be referred to as a first memory chip, and the second memory area may be referred to as a second memory chip. In some other embodiments, the memory chip may refer to a compiled SRAM. For example, a compiled SRAM in which logic such as a write driver and a read driver is defined by being synthesized by a RAM compiler may be a concept corresponding to a memory chip.

The memory chip power controller configuration register 40 may store setting information that may be used for controlling the power mode. For example, the memory chip power controller configuration register 40 may be a register bank that stores a setting value or a control value that enables the memory controller 10, the memory power mode controller 20, and the memory block 300 to operate as intended. The setting information includes, e.g., information related to a threshold value for idle time that is set for each of the memory chips 302 to 308, or when each of the memory chips 302 to 308 is switched to the low power mode, may include setting information for determining whether to be switched to the retention mode or the power down mode. Such setting information may be set in the memory chip power controller configuration register 40 by software.

For example, when power supplied to the memory device 1000 is not sufficiently secured so that power management may need to be actively performed, a threshold value for an idle time may be set to a value that is lower than a reference value predetermined in the memory chip power controller configuration register 40, to quickly switch the power mode of the memory chip for which no access request has occurred to the low power mode even when the counted value is not large. In embodiments, when the power supplied to the memory device 1000 is sufficiently secured to focus on improving performance of the memory device 1000 rather than power management, the threshold value for the idle time may also be set to a value that is higher than a reference value predetermined in the memory chip power controller configuration register 40, to switch the power mode of the memory chip for which no access request has occurred to the low power mode only when the counted value is significantly large.

As another example, when switching to the low power mode depending on a purpose of the memory chip, it may be possible to designate a retention mode to be switched to by default, or otherwise to write a setting value for switching to the power down mode by default in the memory chip power controller configuration register 40. For example, a setting value corresponding to a certain memory chip used for a purpose in which the retention mode is essential among a plurality of memory chips, and when switching to the low power mode, control information for switching to the retention mode may be written in the memory chip power controller configuration register 40. In embodiments, a setting value corresponding to another certain memory chip used for a purpose in which the retention mode is not necessary among the memory chips, and when switching to the low power mode, control information for immediately switching to the power down mode may be written in the memory chip power controller configuration register 40.

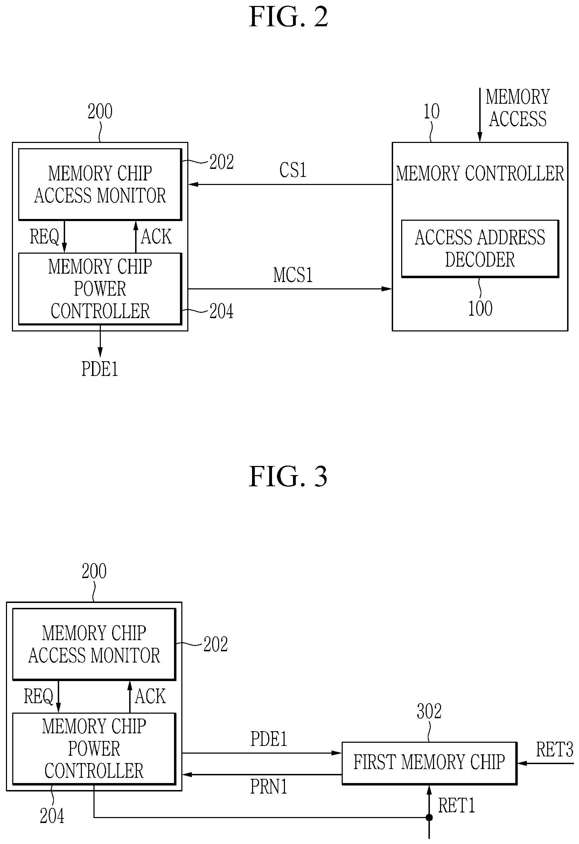

FIG. 2 illustrates a block diagram showing a memory device according to an embodiment.

Referring to FIG. 2, the memory chip access monitor 202 of the memory chip power mode controller 200 may receive and read a chip selection signal CS1 generated by the access address decoder 100. In embodiments, the chip selection signal CS1 may include a value indicating whether an access request to the memory chip 302 occurs or has occurred.

The memory chip access monitor 202 may determine whether to control the power mode of the memory chip 302 in the low power mode or the normal mode depending on whether or not an access request has been made to the memory chip 302 for a predetermined period, and may transmit a request REQ to the memory chip power controller 204 to transmit a control command to the memory chip 302. The memory chip access monitor 202 may count an idle time of the memory chip 302 by using the counter 220, may maintain the power mode of the memory chip 302 in the normal mode before a counted value exceeds a threshold, and when the counted value exceeds the threshold, may switch the power mode of the memory chip 302 to the low power mode. When an access request occurs while counting is performed, for example when the chip selection signal CS1 is changed to a value indicating that an access request has occurred before the counted value reaches a threshold, the memory chip access monitor 202 may initialize (e.g. restart) the counter 220, and may maintain the normal mode.

The memory chip power controller 204 may transmit a response ACK to the request REQ to the memory chip access monitor 202, and may transmit a chip power control signal PDE1 for controlling the power mode of the memory chip 302 to the memory chip 302 depending on determination of the memory chip access monitor 202.

In embodiments, the memory chip power mode controller 200 may provide information related to a state of the memory chip 302 to the memory controller 10 through a signal MCS1. Herein, the signal MCS1 may include information such as whether the memory chip 302 is in a ready state and a currently set power mode.

FIG. 3 illustrates a block diagram showing a memory device according to an embodiment.

Referring to FIG. 3, the memory chip power controller 204 may transmit a chip power control signal PDE1 for controlling the power mode of the memory chip 302 to the memory chip 302, and accordingly, may switch the power mode of the memory chip 302. For example, when the chip power control signal PDE1 includes a command for setting the power mode of the memory chip 302 to the low power mode, the memory chip 302 receiving the command may enter the low power mode. In addition, when the chip power control signal PDE1 includes a command for setting the power mode of the memory chip 302 to the normal mode, the memory chip 302 receiving the command may enter the normal mode.

When entering the low power mode, the memory chip 302 may be set to the retention mode or set to the power down mode depending on the first retention control signal RET1 received from the first memory chip power mode controller 200 or a third retention control signal RET3 received from the outside of the first memory chip power mode controller 200 (e.g. from an external device or system).

In embodiments, the memory chip power mode controller 200 may receive a signal PRN1 indicating what the currently set power mode is from the memory chip 302, and may use it to configure the signal MCS1 and transmit it to the memory controller 10.

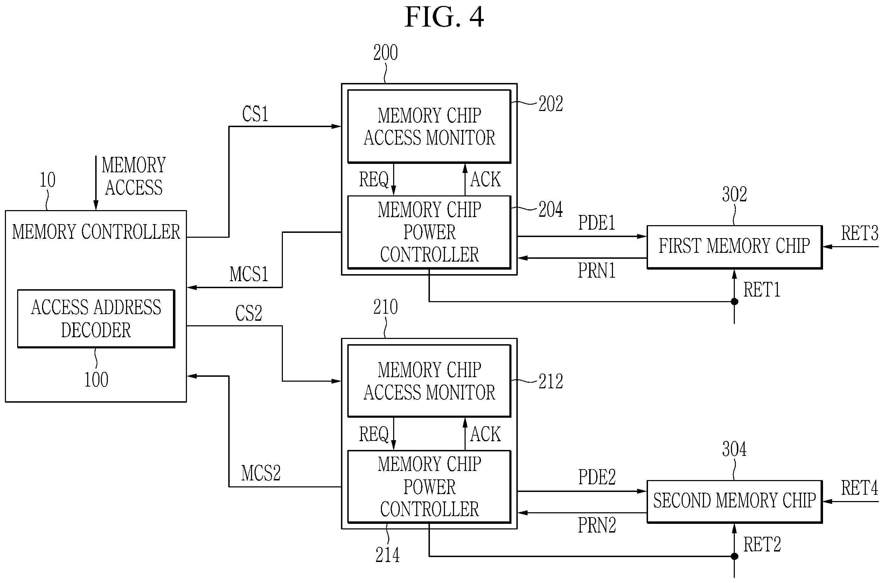

FIG. 4 illustrates a block diagram showing a memory device according to an embodiment.

Referring to FIG. 4, in the memory device according to an embodiment, the access address decoder 100 of the memory controller 10 may output a first chip selection signal CS1 indicating whether an access request to the first memory chip 302 occurs or has occurred and a second chip selection signal CS2 indicating whether an access request to the second memory chip 304 occurs or has occurred.

The first memory chip power mode controller 200 may receive the first chip selection signal CS1 from the access address decoder 100, and may read the first chip selection signal CS1 to control the power mode of the first memory chip 302. To this end, the first memory chip access monitor 202 may determine whether to control the power mode of the first memory chip 302 in the low power mode or the normal mode depending on whether or not an access request has been made to the first memory chip 302 for a predetermined period, and may transmit the request REQ to the first memory chip power controller 204 to transmit a control command to the first memory chip 302.

The first memory chip power controller 204 may transmit the response ACK to the request REQ to the first memory chip access monitor 202, and may transmit the first chip power control signal PDE1 for controlling the power mode of the first memory chip 302 to be switched between the normal mode and the low power mode to the first memory chip 302 depending on determination of the first memory chip access monitor 202. The first memory chip 302 switched to the low power mode may be received from the first memory chip power mode controller 200, or may be set to the retention mode or set to the power down mode depending on the first retention control signal RET1 received from the first memory chip power mode controller 200 or the third retention control signal RET3 received from the outside of the first memory chip power mode controller 200.

The second memory chip power mode controller 210 may receive the second chip selection signal CS2 from the access address decoder 100, and may read the second chip selection signal CS2 to control the power mode of the second memory chip 304. To this end, the second memory chip access monitor 212 may determine whether to control the power mode of the second memory chip 304 in the low power mode or the normal mode depending on whether or not an access request has been made to the second memory chip 304 for a predetermined period, and may transmit the request REQ to the second memory chip power controller 214 to transmit a control command to the second memory chip 304.

The second memory chip power controller 214 may transmit the response ACK to the request REQ to the second memory chip access monitor 212, and may transmit the second chip power control signal PDE2 for controlling the power mode of the second memory chip 302 to be switched between the normal mode and the low power mode to the second memory chip 302 depending on determination of the second memory chip access monitor 212. The second memory chip 304 switched to the low power mode may be received from the second memory chip power mode controller 210, or may be set to the retention mode or set to the power down mode depending on the second retention control signal RET2 received from the second memory chip power mode controller 210 or a fourth retention control signal RET4 received from the outside of the second memory chip power mode controller 210 (e.g. from an external device or system).

In some embodiments, both the first memory chip 302 and the second memory chip 304 may be controlled in the normal mode. In this case, values of the first chip power control signal PDE1 and the second chip power control signal PDE2 may be the same.

In some embodiments, the first memory chip 302 may be controlled in the low power mode, and the second memory chip 304 may be controlled in the normal mode. In this case, the values of the first chip power control signal PDE1 and the second chip power control signal PDE2 may be different from each other.

In some embodiments, both the first memory chip 302 and the second memory chip 304 may be controlled in the low power mode. In this case, the values of the first chip power control signal PDE1 and the second chip power control signal PDE2 may be the same.

When both the first memory chip 302 and the second memory chip 304 are controlled in the low power mode, in some embodiments, both the first memory chip 302 and the second memory chip 304 may be controlled in the retention mode. In this case, the values of the first chip power control signal PDE1 and the second chip power control signal PDE2 may be the same, and the values of the first retention control signal RET1 and the second retention control circuit RET2 may also be the same.

When both the first memory chip 302 and the second memory chip 304 are controlled in the low power mode, in some embodiments, both the first memory chip 302 and the second memory chip 304 may be controlled in the power down mode. In this case, the values of the first chip power control signal PDE1 and the second chip power control signal PDE2 may be the same, and the values of the first retention control signal RET1 and the second retention control circuit RET2 may also be the same.

When both the first memory chip 302 and the second memory chip 304 are controlled in the low power mode, in some embodiments, the first memory chip 302 may be controlled in the retention mode, and the second memory chip 304 may be controlled in the power down mode. In this case, the values of the first chip power control signal PDE1 and the second chip power control signal PDE2 may be the same, and the values of the first retention control signal RET1 and the second retention control circuit RET2 may also be different.

The values of the first retention control signal RET1 and the second retention control circuit RET2 may be determined in various ways. For example, the values of the first retention control signal RET1 and the second retention control circuit RET2 may be determined depending on information that is set in the memory chip power controller configuration register 40, and may be determined by using information that is stored in a separate memory or storage, or may be provided by another control circuit.

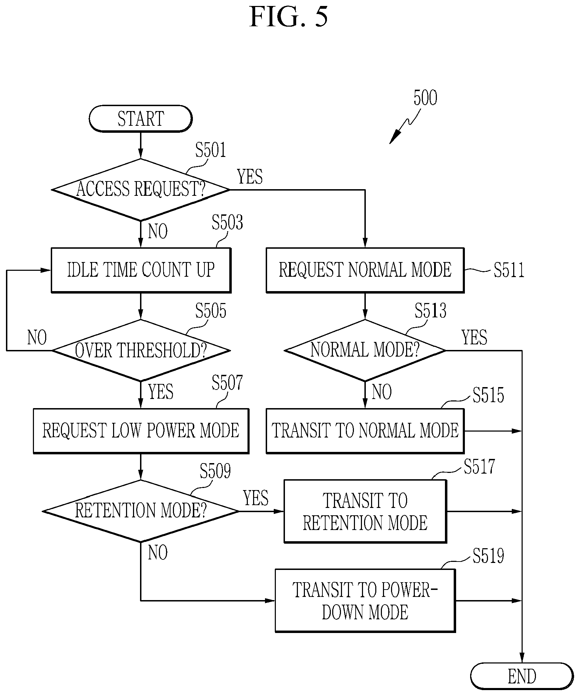

FIG. 5 illustrates a flowchart showing a process 500 for operating a memory device according to another embodiment.

Referring to FIG. 5, in the process 500, in operation S501, it may be determined whether an access request occurs or has occurred in units of memory chips (e.g. for each memory chip). Operation S501 may be performed based on a result of decoding an access address from the memory access request.

In operation S503, an idle time for a memory chip for which an access request has not occurred may be counted up. Then, in operation S505, the process 500 may proceed to operation S507 when the counted idle time exceeds a threshold, and may proceed to operation S503 when the counted idle time does not exceed the threshold.

In the process 500, when the counted value exceeds the threshold, a power mode of the memory chip for which the access request has not occurred may be switched to a low power mode, and for example, in operation S507, the memory chip access monitor 202 may be used to request the low power mode. Next, depending on the method, in operation S509, a retention control signal RET may be checked. When the retention control signal RET includes a request or command for a retention mode, the process 500 may proceed to operation S517 to control the power mode of the memory chip for which the access request has not occurred in the retention mode.

In embodiments, when the retention control signal RET includes no request or command for the retention mode, or includes a request or command for a power down mode, the process 500 may proceed to operation S519 to control the power mode of the memory chip for which the access request has not occurred in the power down mode.

In embodiments, when an access request occurs or has occurred in operation S501, the process 500 may proceed to operation S511 to request a normal mode using the memory chip access monitor 202. In operation S513, whether a current state is the normal mode may be checked, when the current state is already in the normal mode, the corresponding mode may be maintained, and when the current state is in a low power mode, the power mode may be switched to the normal mode by proceeding to operation S515. A normal mode may be a mode that is not a low power mode (e.g. is not a retention mode or power-down mode). That is, a normal mode may be a mode that utilizes more power than the low power mode.

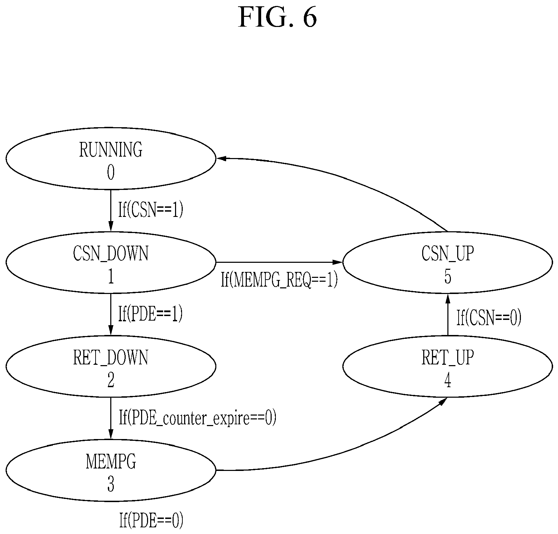

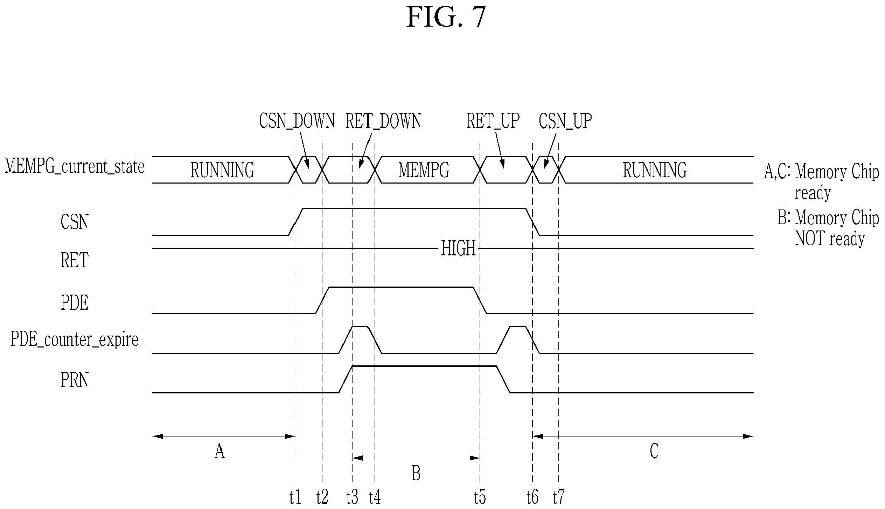

FIG. 6 illustrates an operation of a memory device according to an embodiment, and FIG. 7 illustrates a waveform diagram showing an operation of a memory device according to an embodiment.

Referring to FIG. 6 and FIG. 7, a memory chip power controller for transmitting a command for controlling a power mode of a memory chip to a memory chip may include a state machine, and the state machine may perform state transition as illustrated in FIG. 6. Then, a waveform of a signal depending on the state transition is illustrated in FIG. 7.

The memory chip may be in a ready state during a period A before a time t1 and a period C after a time t7, and may be in a not-ready state during a period B from a time t3 to a time t5.

During the section A, which corresponds to a state 0 ("RUNNING"), a chip selection signal CSN, a chip power control signal PDE, a counter expiration signal PDE_counter_expire, and a signal PRN indicating a current power mode maintain a logic low, and a retention control signal RET may maintain a logic high.

A transition may occur from the state 0 to a state 1 ("CSN_DOWN") while the chip selection signal CSN transitions to the logic high. The state 1 may correspond to the times t1 to t2. The transition of the chip selection signal CSN to the logic high may indicate that a memory chip for which an access request has not occurred has been found.

A transition may occur from the state 1 to the state 2 ("RET_DOWN") while the chip power control signal PDE transitions to the logic high. The state 2 may correspond to the time t2 to a time t4. A transition of the chip power control signal PDE to the logic high may indicate that the memory chip has started counting an idle time for a memory chip for which no access request has occurred.

In the state 2, at a time t3, the memory chip may enter a low power mode while the counter expiration signal PDE_counter_expire transitions to the logic high. Accordingly, the signal PRN indicating the current power mode may also transition to a logic high indicating the low power mode.

At a time t4, a transition from the state 2 to a state 3 ("MEMPG") may occur while the counter expiration signal PDE_counter_expire transitions to the logic low. The state 3 may correspond to the time t4 to a time t5. The transition of the counter expiration signal PDE_counter_expire to the logic low may indicate that a counter is reset. Because the memory chip may enter the low power mode from the time t3, the memory chip may be in the not-ready state until the time t5.

A transition may occur from the state 3 to the state 4 ("RET_UP") while the chip power control signal PDE transitions to the logic low. The state 4 may correspond to the time t5 to a time t6. The transition of the chip power control signal PDE to the logic low may indicate that the power mode of the memory chip is controlled in the normal mode. However, in this state, the chip selection signal CSN may be still at the logic high. Accordingly, the counter may operate after the chip power control signal PDE is transitioned to the logic low and the signal PRN representing the current power mode is switched to a logic low indicating the normal mode.

A transition may occur from the state 4 to a state 5 ("CSN_UP") while the chip selection signal CSN transitions to the logic low. The state 5 may correspond to the time t6 to a time t7. Thereafter, the state 5 may be transitioned back to the state 0, a chip selection signal CSN, a chip power control signal PDE, a counter expiration signal PDE_counter_expire, and a signal PRN indicating a current power mode maintain a logic low, and a retention control signal RET may maintain a logic high.

When a memory chip for which no access request has occurred in the state 1 is found and the chip selection signal CSN transitions to the logic high, and a memory access request for the corresponding memory chip occurs (MEMPG_REQ==1), the state machine may immediately transition to the state 5 and may not enter the low power mode without going through the states 2 to 4, including the not-ready state.

The memory chip power controller may control the power mode of the memory chip by using such a state machine, but embodiments are not limited to the configuration of the above-described state machine, and it may be changed such that different states and state transitions occur depending on a specific implementation purpose.

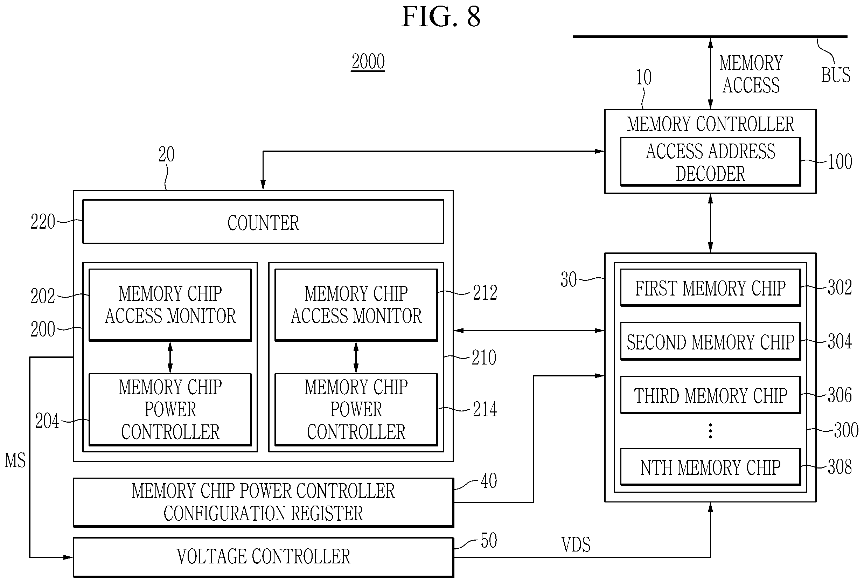

FIG. 8 illustrates a block diagram showing a memory device according to an embodiment.

Referring to FIG. 8, a memory device 2000 according to an embodiment may include a memory controller 10, a memory power mode controller 20, a memory 30, a memory chip power controller configuration register 40, and a voltage controller 50. For details on the memory controller 10, the memory power mode controller 20, the memory block 300, and the memory chip power controller configuration register 40, reference may be made to the above description in relation to FIG. 1 to FIG. 7, and therefore the voltage controller 50 are mainly described below with respect to FIG. 8.

The voltage controller 50 may control a cell voltage for the memory block 300. For example, the memory power mode controller 20 may transmit a memory state signal MS indicating a power state of the memory block 300 to the voltage controller 50, and the voltage controller 50 may transmit a cell voltage control signal VDS for controlling a cell voltage depending on the memory state signal MS to the memory block 300. The memory 30 (e.g. the memory block 300) may be configured to control the cell voltage for each memory chip 302-308 depending on the cell voltage control signal VDS.

In some embodiments, when all memory chips of the memory block 300 are set to a retention mode, the voltage controller 50 may recognize this through the memory state signal MS, and may transmit the cell voltage control signal VDS to the memory block 300. The cell voltage applied to the memory block 300 (e.g. applied to the memory chips 302-308 in the memory block 300) may be reduced depending on the cell voltage control signal VDS, so that a power saving effect may be doubled. That is, the memory 30 may be configured to reduce the cell voltage applied to all memory chips in the memory block 300 in response to all memory chips of the memory block 300 being set to a retention mode. The memory 30 may be configured to determine this based on the cell voltage control signal VDS.

In some embodiments, when all memory chips of the memory block 300 are set to a power down mode, the voltage controller 50 may recognize this through the memory state signal MS, and may transmit the cell voltage control signal VDS to the memory block 300. The application of the cell voltage to the memory block 300 (e.g. applied to the memory chips 302-308 in the memory block 300) may be stopped depending on the cell voltage control signal VDS, so that the power saving effect may be doubled. That is, the memory 30 may be configured to stop the application of the cell voltage to all memory chips in the memory block 300 in response to all memory chips of the memory block 300 being set to a power down mode. The memory 30 may be configured to determine this based on the cell voltage control signal VDS

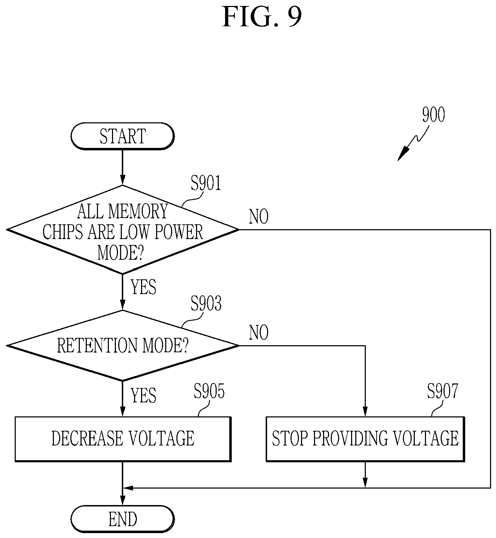

FIG. 9 illustrates a flowchart showing a process 900 for operating a memory device according to another embodiment.

Referring to FIG. 9, in operation S901, it may be determined whether all the memory chips have entered the low power mode. When it is determined that all the memory chips have entered the low power mode, the process 900 may determine whether all the memory chips are in the retention mode in operation S903.

When it is determined that all the memory chips are in the retention mode, depending on the method, the process 900 may proceed to operation S905 to lower the cell voltage applied to the memory block 300. In embodiments, when it is determined that all memory chips are in the power down mode, depending on the method, the process 900 may proceed to operation S907 to stop application of the cell voltage to the memory block 300.

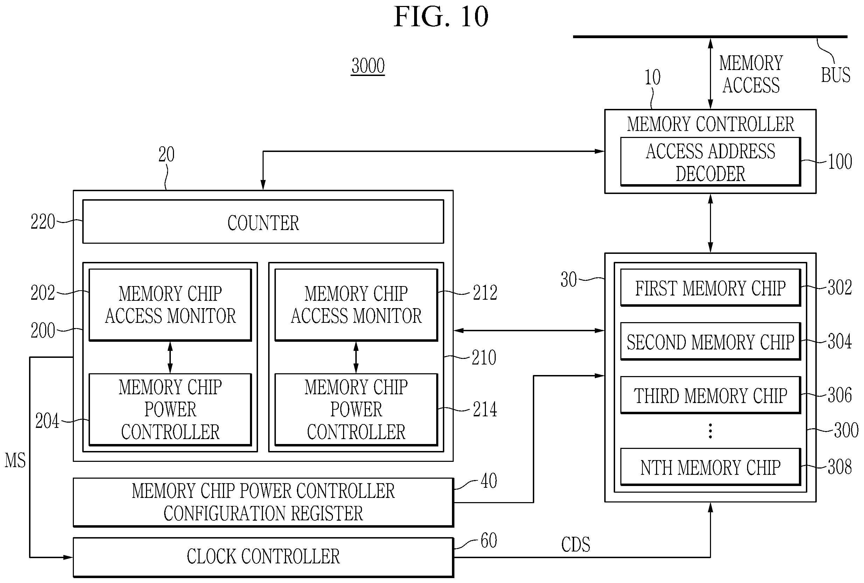

FIG. 10 illustrates a block diagram showing a memory device according to an embodiment.

Referring to FIG. 10, a memory device 3000 according to an embodiment may include a memory controller 10, a memory power mode controller 20, a memory 30, a memory chip power controller configuration register 40, and a clock controller 60. For details on the memory controller 10, the memory power mode controller 20, the memory block 300, and the memory chip power controller configuration register 40, reference may be made to the above description in relation to FIG. 1 to FIG. 7, and therefore the clock controller 60 is mainly described below with respect to FIG. 10.

The clock controller 60 may perform clock gating on the memory block 300. For example, the memory power mode controller 20 may transmit a memory state signal MS indicating a power state of the memory block 300 to the clock controller 60, and the clock controller 60 may transmit a clock control signal CDS for controlling a clock depending on the memory state signal MS to the memory block 300.

In some embodiments, when all memory chips of the memory block 300 are set to a low power mode, the clock controller 60 may recognize this through the memory state signal MS, and may transmit the clock control signal CDS to the memory block 300. The clock gating may be performed on the memory block 300 (e.g. by the memory 30) depending on the clock control signal CDS, so that the power saving effect may be doubled. That is, the memory 30 may be configured to perform clock gating based on receipt of the clock control signal CDS.

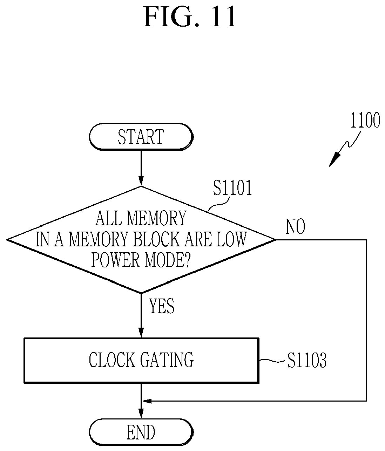

FIG. 11 illustrates a flowchart showing a process 1100 for operating a memory device according to another embodiment.

Referring to FIG. 11, in operation S1101, it may be determined whether all the memory chips have entered the low power mode. When it is determined that all the memory chips have entered the low power mode, the process 1100 may proceed to operation S1103 to perform the clock gating on the memory block 300. Clock gating may include stopping the application of the clock in the memory block 300.

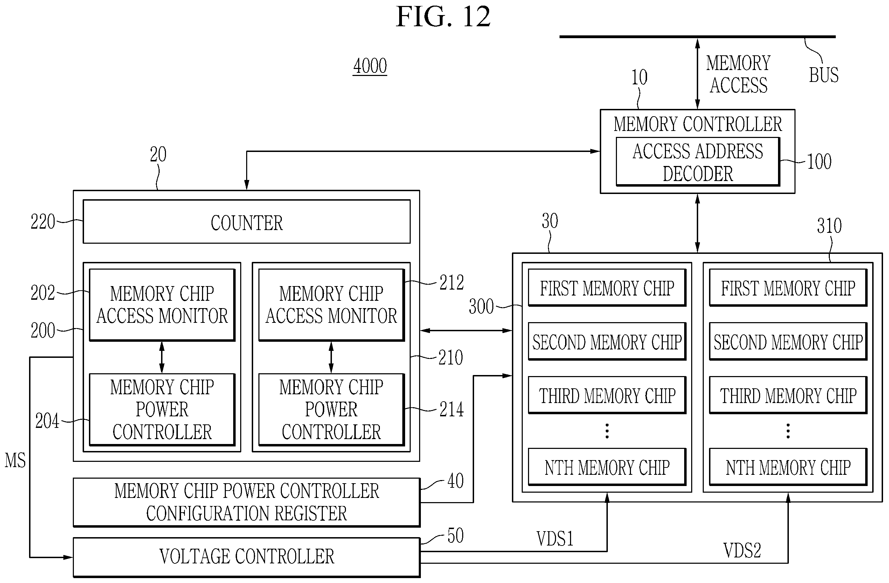

FIG. 12 illustrates a block diagram showing a memory device according to an embodiment.

Referring to FIG. 12, the memory device 4000 according to an embodiment may differ from the embodiment illustrated in FIG. 8 in that the memory 30 may include a plurality of memory blocks 300 and 310.

The voltage controller 50 may control a cell voltage for each of a first memory block 300 and a second memory block 310. For example, the memory power mode controller 20 may transmit the memory state signal MS indicating the power states of the first memory block 300 and the second memory block 310 to the voltage controller 50, and the voltage controller 50 may transmit a first cell voltage control signal VDS1 and a second cell voltage control signal VDS2 to the first memory block 300 and the second memory block 310, respectively, depending on the memory state signal MS. The first memory block 300 and the second memory block 310 may adjust their respective cell voltages based on the received cell voltage control signals VDS1 and VDS2.

In some embodiments, when all the memory chips of the first memory block 300 are set to the retention mode and all the memory chips of the second memory block 310 are set to the power down mode, a cell voltage applied to the first memory block 300 may decrease depending on the first cell voltage control signal VDS1, and application of a cell voltage to the second memory block 310 may be stopped depending on the second cell voltage control signal VDS2.

In some embodiments, when all the memory chips of the first memory block 300 are set to the normal mode and all the memory chips of the second memory block 310 are set to the retention mode, the cell voltage applied to the first memory block 300 may be maintained as it is depending on the first cell voltage control signal VDS1, and the cell voltage to the second memory block 310 may be reduced depending on the second cell voltage control signal VDS2.

In some embodiments, when all the memory chips of the first memory block 300 are set to the normal mode and all the memory chips of the second memory block 310 are set to the power down mode, a cell voltage applied to the first memory block 300 may be maintained as it is depending on the first cell voltage control signal VDS1, and application of a cell voltage to the second memory block 310 may be stopped depending on the second cell voltage control signal VDS2.

The embodiment of FIG. 11 may also be applied in the same manner as described above. For example, when the memory 30 includes the memory blocks 300 and 310, the clock controller 60 may control a clock for each of the first memory block 300 and the second memory block 310. For example, the memory power mode controller 20 may transmit the memory state signal MS indicating the power states of the first memory block 300 and the second memory block 310 to the clock controller 60, and the clock controller 60 may transmit a first clock control signal CDS1 and a second clock control signal CDS2 to the first memory block 300 and the second memory block 310, respectively, depending on the memory state signal MS.

In some embodiments, when all the memory chips of the first memory block 300 are set to the normal mode and all the memory chips of the second memory block 310 are set to the low power mode, the clock applied to the first memory block 300 may be maintained as it is depending on the first clock control signal CDS1, and clock gating may be performed on the second memory block 310 depending on the second cell voltage control signal CDS2.

In some embodiments, the cell voltage reduction or stopping of the cell voltage control signal VDS or the clock gating using the clock control signal CDS may be performed for each memory block or for each memory chip. For example, when one memory block including a plurality of memory chips is set to the low power mode, the cell voltage reduction or stopping of the cell voltage control signal VDS may be performed only for some memory chips among the memory chips. Similarly, the clock gating using the clock control signal CDS may be performed only on some of the memory chips.

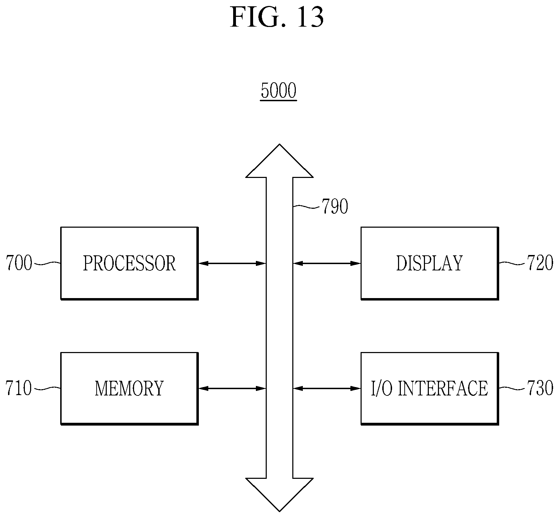

FIG. 13 illustrates a view for describing a semiconductor system 5000 according to an embodiment.

Referring to FIG. 13, the semiconductor system 5000 according to an embodiment may include a processor 700, a memory device 710, a display 720, and an input and output (I/O) interface 730. The processor 700, the memory device 710, the display 720, and the I/O interface 730 may exchange data with each other through a bus 790. The semiconductor system 5000 may further include other general-purpose components, and some of the illustrated elements may be omitted.

The processor 700 may control an overall operation of each component of the semiconductor system 5000. The processor 700 may be implemented as at least one of various processing units such as a central processing unit (CPU), an application processor (AP), and a graphics processing unit (GPU).

The memory device 710 may store various data and commands. The memory device 710 may include a volatile memory such as a SRAM, a DRAM, and/or a nonvolatile memory such as a flash memory. For example, the memory device 710 may be implemented as the memory device described above with reference to FIG. 1 to FIG.12.

The memory controller 10 according to the above-described embodiments may be implemented in the memory device 710 to exchange data with the processor 700 through the bus 790. In embodiments, the memory controller 10 according to the above-described embodiments may be mounted on the processor 700 to transmit and receive data to and from the memory device 710 including the memory cell through the bus 790.

The display 720 may display image data applied through the bus 790 on a panel. The input and output interface 730 may be connected to an input or output device inside or outside the semiconductor system 5000 to perform input or output.

In embodiments, although the memory device and the operating method for the memory device according to the embodiments of the present disclosure have been mainly described with respect to SRAM, embodiments are not limited thereto, and the memory device and the operating method for the memory device according to the embodiments of the present disclosure may be applied to any memory device requiring low power operation. For example, even in the case of a DRAM, it may be possible to control a power mode in units of memory chips by applying ideas described in the embodiments of the present disclosure.

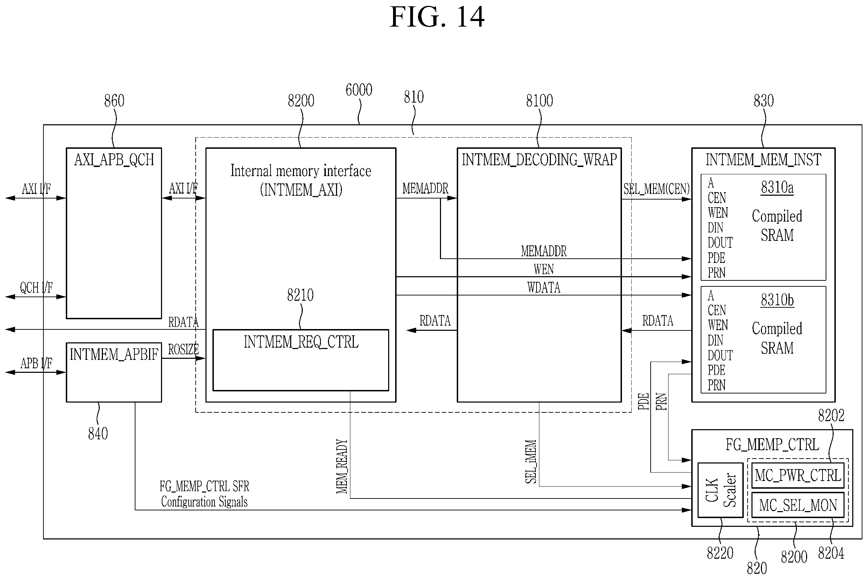

FIG. 14 illustrates a view for describing a semiconductor system according to an embodiment.

Referring to FIG. 14, a semiconductor system 6000 according to an embodiment may include a memory controller 810, a memory power mode controller 820, a memory 830, a memory chip power controller configuration register 840, and a bus interface 860.

The memory controller 810 may include an access address decoder 8100 and an internal memory interface 8200. The access address decoder 8100 may decode an access address from the memory access request. In addition, the access address decoder 8100 may output a chip selection signal SEL_iMEM to the memory power mode controller 820 based on a decoding result thereof. The internal memory interface 8200 may transfer a memory access request occurred from an external device such as a host through the bus interface 860 to the access address decoder 8100, and may include a request controller 8210 that controls and manages such requests.

The memory power mode controller 820 may read a chip selection signal SEL_iMEM generated by the access address decoder 8100 to control a power mode of a memory chip for which an access request has not occurred for a predetermined period among the memory chips 8310a and 8310b in a low power mode, and may control the power mode of the memory chip for which an access request occurs or has occurred in a normal mode. For example, the memory power mode controller 820 may count an idle time of a memory chip for which an access request does not occur by using the counter 8220, until a counted value exceeds a threshold, may maintain a power mode of the memory chip for which no access request has occurred in the normal mode, and when the counted value exceeds the threshold value, may switch the power mode of the memory chip for which the access request has not occurred to the low power mode. When an access request occurs while counting is performed, i.e., when a chip selection signal is changed to a value indicating that an access request has occurred before the counted value reaches a threshold, the memory power mode controller 820 may initialize the counter 8220, and may maintain the normal mode.

The memory power mode controller 820 may include at least one memory chip power mode controller 8200, and the memory chip power mode controller 8200 may include a memory chip access monitor 8204 and a memory chip power controller 8202. The memory chip power controller 8202 may transfer a chip power control signal PDE for controlling the power mode of the memory chip to the memory chip, and accordingly, the power mode of the memory chip may be switched. For example, when the chip power control signal PDE includes a command for setting the power mode of the memory chip to the low power mode, the memory chip receiving the command may enter the low power mode. In addition, when the chip power control signal PDE includes a command for setting the power mode of the memory chip to the normal mode, the memory chip receiving the command may enter the normal mode. In embodiments, the memory chip power mode controller 8200 may receive a signal PRN indicating what a currently set power mode is from the memory chip, and may transfer it to the memory controller 810.

The memory 830 may include at least one memory block, and the memory block may include a plurality of memory chips 8310a and 8310b. As described above, the power mode may be controlled for each of the memory chips 8310a and 8310b by the memory power mode controller 820. Herein, each of the memory chips 8310a and 8310b may correspond to a compiled SRAM.

The memory chip power controller configuration register 840 may be connected to a bus outside the semiconductor system 6000. The memory chip power controller configuration register 840 may store setting information that is used for control or operation of the memory controller 810, and may provide it to the memory controller 810. In addition, the memory chip power controller configuration register 840 may store setting information that is used for controlling the power mode, and may provide it to the memory power mode controller 820. In this case, the setting information includes, e.g., information related to a threshold value for idle time that is set for each of the memory chips 8310a and 8310b, or when each of the memory chips 8310a and 8310b are switched to the low power mode, may include setting information for determining whether to be switched to the retention mode or the power down mode.

The bus interface 860 may provide an interface between the memory controller 810 and the bus outside the semiconductor system 6000. For example, in the present embodiment, the bus interface 860 may provide an advanced extensible interface (AXI), an advanced peripheral bus (APB), and a q-channel interface. For example, the memory controller 810 may be connected to the bus outside the semiconductor system 6000 through the bus interface 860.

For more details on the memory controller 810, the memory power mode controller 820, the memory 830, and the memory chip power controller configuration register 840, reference may be made to the memory controller 10, the memory power mode controller 20, the memory 30, and the memory chip power controller configuration register 40 described above with reference to FIG. 1 to FIG. 12.

While this disclosure has been described in connection with various embodiments, it is to be understood that the disclosure is not limited to the disclosed embodiments, but, on the contrary, is intended to cover various modifications and equivalent arrangements included within the scope of the appended claims.

## Claims

1. A memory device comprising:
a memory block comprising a plurality of memory chips;
an access address decoder configured to:
decode an access address based on a memory access request, and
output a chip selection signal indicating whether an access request has occurred in units of memory chips based on the decoded access address;
a memory power mode controller configured to:
read the chip selection signal,
based on the access request having not occurred for a first memory chip for a predetermined period, control a power mode of the first memory chip to be a low power mode, and
based on the access request having occurred for a second memory chip within the predetermined period, control a power mode of the second memory chip to be a normal mode; and
a memory chip power controller configuration register configured to store setting information for controlling the power mode.

2. The memory device of claim 1, wherein the memory power mode controller is further configured to:
count an idle time of the first memory chip using a counter,
maintain the power mode of the first memory chip as the normal mode before a count value of the counter exceeds a threshold, and
switch the power mode of the first memory chip to the low power mode based on the count value exceeding the threshold.

3. The memory device of claim 2, wherein the memory power mode controller is further configured to:
initialize the counter and maintain the normal mode based the chip selection signal changing to a value indicating that the access request has occurred for the first memory chip before the count value reaches the threshold.

4. The memory device of any preceding claim, wherein the chip selection signal comprises a first chip selection signal indicating whether the access request has occurred for the first memory chip, and a second chip selection signal indicating whether the access request has occurred for the second memory chip, and
wherein the memory power mode controller comprises:
a first memory chip power mode controller configured to receive the first chip selection signal from the access address decoder and read the first chip selection signal to control the power mode of the first memory chip; and
a second memory chip power mode controller configured to receive the second chip selection signal from the access address decoder and read the second chip selection signal to control the power mode of the second memory chip.

5. The memory device of claim 4, wherein the first memory chip power mode controller is further configured to transmit a first chip power control signal for switching the power mode of the first memory chip between the normal mode and the low power mode to the first memory chip, and
the second memory chip power mode controller is further configured to transmit a second chip power control signal for switching the power mode of the second memory chip between the normal mode and the low power mode to the second memory chip.

6. The memory device of claim 5, wherein the first memory chip switched to the low power mode is configured to be set to a retention mode or a power down mode based on a first retention control signal received from the first memory chip power mode controller or an outside of the memory device, and
wherein the second memory chip switched to the low power mode is configured to be set to the retention mode or the power down mode based on a second retention control signal received from the second memory chip power mode controller or the outside of the memory device.

7. The memory device of claim 6, wherein values of the first retention control signal and the second retention control signal are determined based on information set in the memory chip power controller configuration register.

8. A memory device comprising:
a first memory block comprising a first memory chip and a second memory chip;
a memory power mode controller configured to control a power mode of the first memory chip and a power mode of the second memory chip; and
a voltage controller configured to control a cell voltage for the first memory block,
wherein the memory power mode controller is further configured to transmit a first memory state signal indicating a power state of the first memory block to the voltage controller, and
wherein the voltage controller is further configured to transmit a first cell voltage control signal for controlling the cell voltage to the first memory block based on the first memory state signal.

9. The memory device of claim 8, configured such that a cell voltage applied to the first memory block decreases according to the first cell voltage control signal based on all memory chips of the first memory block being set to a retention mode.

10. The memory device of claim 8 or claim 9, configured such that application of a cell voltage to the first memory block is stopped according to the first cell voltage control signal based on all memory chips of the first memory block being set to a power down mode.

11. The memory device of any of claims 8-10, further comprising a second memory block comprising a third memory chip and a fourth memory chip,
wherein the memory power mode controller is further configured to control a power mode of the third memory chip and a power mode of the fourth memory chip,
wherein the voltage controller is further configured to control a cell voltage for the second memory block,
wherein the memory power mode controller is further configured to transmit a second memory state signal indicating a power state of the second memory block to the voltage controller, and
wherein the voltage controller is further configured to transmit a second cell voltage control signal to the second memory block based on the second memory state signal.

12. The memory device of claim 11, configured such that, based on all memory chips of the first memory block being set to a retention mode and all memory chips of the second memory block being set to a power down mode, a first cell voltage applied to the first memory block decreases according to the first cell voltage control signal, and application of a second cell voltage to the second memory block is stopped according to the second cell voltage control signal.

13. The memory device of claim 11 or claim 12, configured such that, based on all memory chips of the first memory block being set to a normal mode and all memory chips of the second memory block being set to a retention mode, a first cell voltage applied to the first memory block is maintained according to the first cell voltage control signal, and a second cell voltage applied to the second memory block decreases according to the second cell voltage control signal.

14. The memory device of any of claims 11-13, configured such that, based on all memory chips of the first memory block being set to a normal mode and all memory chips of the second memory block being set to a power down mode, a first cell voltage applied to the first memory block is maintained according to the first cell voltage control signal, and application of a second cell voltage to the second memory block is stopped according to the second cell voltage control signal.

15. An operating method for a memory device, the operating method comprising:
decoding an access address based on a memory access request;
determining whether an access request has occurred in units of memory chips based on the decoded access address;
counting an idle time for a memory chip for which the access request has not occurred; and
switching a power mode of the memory chip to a low power mode based on a count value corresponding to the counted idle time exceeding a threshold.
